# EUROPEAN PATENT APPLICATION

(11) **EP 2 390 925 A1**
(43) Date of publication of application: **30.11.2011**
(21) Application number: 10164499.5
(22) Date of filing: 31.05.2010
(51) Int. Cl.: H01L 31/18, H01L 21/00

(54) **Thin film solar fabrication process, etching method, device for etching, and thin film solar device**

(71) Applicant: Applied Materials, Inc., Santa Clara, CA 95054 (US)
(72) Inventor: Kuhr, Niels, 63739, Aschaffenburg (DE); Schmidt, Ursula, 63755, Alzenau (DE)
(74) Representative: Zimmermann & Partner

(57) **Abstract**

Methods and devices for etching a device precursor are provided. For example, a method includes: providing a substrate, determining a temperature associated with the substrate, and etching a metal oxide layer of the substrate, wherein the etching is controlled based on the determined temperature.

## Description

### BACKGROUND OF THE INVENTION

### Field of the Invention

Embodiments of the present invention generally relate to etching, and devices for etching, particularly during manufacturing of solar cells. For example, embodiments of the present invention relate to a process of forming solar cells and a device for forming a solar cell. Particularly, they relate to a method for etching a semiconductor device precursor and a device for etching a semiconductor device precursor.

### Description of the Related Art

Crystalline silicon solar cells and thin film solar cells are two types of solar cells. Crystalline silicon solar cells typically use either monocrystalline substrates (i.e., single-crystal substrates of pure silicon) or multi-crystalline silicon substrates (i.e., poly-crystalline or polysilicon). Additional film layers are deposited onto the silicon substrates to improve light capture, form the electrical circuits, and protect the devices. Thin-film solar cells use thin layers of materials deposited on suitable substrates to form one or more p-n junctions. Suitable substrates include glass, metal, and polymer substrates.

To expand the economic uses of solar cells, efficiency must be improved. Solar cell stabilized efficiency relates to the proportion of incident radiation converted into useful electricity. To be useful for more applications, solar cell efficiency must be improved beyond the current best performance of approximately 10% for Si based Thin Film solar modules. With energy costs rising, there is a need for improved thin film solar cells and methods and apparatuses for forming the same in a factory environment.

In order to improve the efficiency of a solar cell, light trapping is one aspect that can be improved. In order to improve trapping of the photons surface texture at the light entering surface can be utilized.

Another aspect for improving mass production of solar cells is the use of large scale processes and the reliability at which processes can be conducted. Thus, there is a desire to improve the processes for increasing the efficiency on a large scale and for applications during industrial manufacturing.

### SUMMARY OF THE INVENTION

In light of the above, a method for etching a semiconductor device precursor according to independent claim 1 and a device for etching a semiconductor device precursor according to independent claim 9 are provided.

Embodiments of the invention provide methods of etching semiconductor device precursors, particularly front contact surfaces of solar cells. According to one embodiment a method for etching a device precursor is provided. The method includes: providing a substrate, determining a temperature associated with the substrate, and etching a metal oxide layer of the substrate, wherein the etching is controlled based on the determined temperature.

Further embodiments provide a device for etching a device precursor is provided. The device includes a substrate support adapted to support a substrate, a temperature sensing device adapted to determine a temperature associated with the substrate, an etching device adapted to etch a metal oxide layer of the substrate, and a control device adapted to control the etching device based on the determined temperature associated with the substrate.

### BRIEF DESCRIPTION OF THE DRAWINGS

So that the manner in which the above recited features of the present invention are attained and can be understood in detail, a more particular description of the invention, briefly summarized above, may be had by reference to the embodiments thereof, which are illustrated in the appended drawings.

Figure 1 is a schematic side-view of a tandem junction thin-film solar cell according to one embodiment of the invention;

Figure 2 is a schematic side-view of a single junction thin-film solar cell according to one embodiment of the invention;

Figures 3A and 3B are schematic side-views of a front surface of a semiconductor precursor illustrating light trapping, which can be for example utilized for a solar cell.

Figure 4 is a schematic graph illustrating a dependency of a substrate temperature from an etch rate;

Figure 5 is a schematic flow chart of a method of etching a semiconductor device precursor according to embodiments described herein;

Figure 6 is a schematic side view illustrating embodiments of devices for etching a semiconductor device precursor according to embodiments described herein, which can for example be utilized in a process line for manufacturing a solar cell;

Figure 7 is a schematic side view illustrating further embodiments of devices for etching a semiconductor device precursor according to embodiments described herein, which can for example be utilized in a process line for manufacturing a solar cell; and

Figure 8 is a schematic side view illustrating yet further embodiments of devices for etching a semiconductor device precursor according to embodiments described herein, which can for example be utilized in a process line for manufacturing a solar cell.

To facilitate understanding, identical reference numerals have been used, where possible, to designate identical or similar elements that are common to the figures. It is contemplated that elements and features of one embodiment may be beneficially incorporated in other embodiments without further recitation.

It is to be noted, however, that the appended drawings illustrate only exemplary embodiments of this invention and are therefore not to be considered limiting of its scope, for the invention may admit to other equally effective embodiments.

### DETAILED DESCRIPTION

Reference will now be made in detail to the various embodiments of the invention, one or more examples of which are illustrated in the figures. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

The term "substrate" as used herein shall embrace both inflexible substrates, e.g. a wafer or a glass plate, and flexible substrates such as webs and foils.

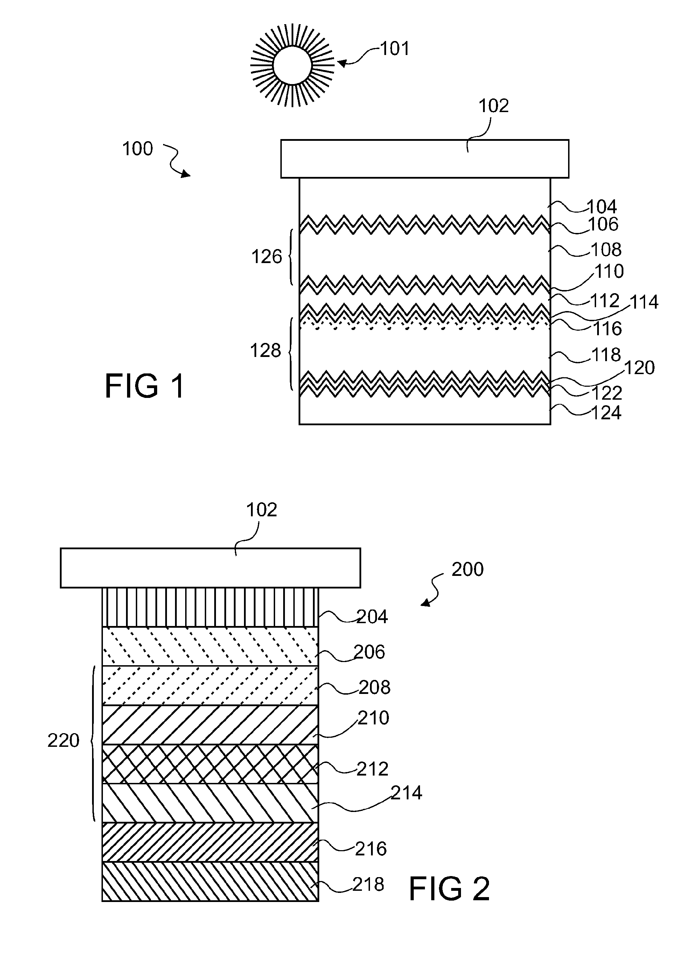

Embodiments described herein relate to processes for the etching of substrate precursors, a method of forming solar cells including etching of substrate precursors, devices for etching substrate precursors, and layer stacks for solar cells being based on substrate precursors with etching processes as described herein. Thereby, reference is for example made to the solar cells as described below and explained in further detail with respect to Figs. 1 and 2.

Thin-film solar cells are generally formed from numerous types of films, or layers, put together in many different ways. Most films used in such devices incorporate a semiconductor element that may comprise silicon, germanium, carbon, boron, phosphorous, nitrogen, oxygen, hydrogen and the like. Characteristics of the different films include degrees of crystallinity, dopant type, dopant concentration, film refractive index, film extinction coefficient, film transparency, film absorption, and conductivity. Typically, most of these films can be formed by use of a chemical vapor deposition process, which may include some degree of ionization or plasma formation and/or sputtering processes.

Sputtering is a process in which atoms are ejected from a solid target material due to bombardment of the target by energetic particles. The process of coating a substrate as a material at the scraping refers typically to thin film applications. The term "coating" and the term "depositing" are used synonymously herein. The terms "sputtering installation" and "deposition apparatus" are used synonymously herein and shall embrace for example an apparatus which uses sputtering for depositing a target material, typically as a thin film, on a substrate. Typical target materials include (but are not limited to) pure metals such as aluminum (A1), copper (Cu), silver (Ag) and gold (Au), metal alloys such as an aluminum-niobium (AINb) alloy or an aluminum-nickel (AINi) alloy, semiconductor materials such as silicon (Si) and dielectric materials such as nitrides, carbides, titanates, silicates, aluminates and oxides, e.g. transparent conducting oxides (TCO) such as impurity-doped ZnO, In₂O₃, SnO₂ and CdO, as well as Sn doped In₂O₃ (ITO) and F doped SnO₂.

According to different embodiments, a plurality of films can be used in solar cells. Charge generation during a photovoltaic process is generally provided by a bulk semiconductor layer, such as a silicon containing layer. The bulk layer is also sometimes called an intrinsic layer to distinguish it from the various doped layers present in the solar cell. The intrinsic layer may have any desired degree of crystallinity, which will influence its light-absorbing characteristics. For example, an amorphous intrinsic layer, such as amorphous silicon, will generally absorb light at different wavelengths from intrinsic layers having different degrees of crystallinity, such as microcrystalline silicon. For this reason, most solar cells will use both types of layers to yield the broadest possible absorption characteristics. In some instances, an intrinsic layer may be used as a buffer layer between two dissimilar layer types to provide a smoother transition in optical or electrical properties between the two layers.

Silicon and other semiconductors can be formed into solids having varying degrees of crystallinity. Solids having essentially no crystallinity are amorphous, and silicon with negligible crystallinity is referred to as amorphous silicon. Completely crystalline silicon is referred to as crystalline, polycrystalline, or monocrystalline silicon. Polycrystalline silicon is crystalline silicon formed into numerous crystal grains separated by grain boundaries. Monocrystalline silicon is a single crystal of silicon. Solids having partial crystallinity, that is a crystal fraction between about 5% and about 95%, are referred to as nanocrystalline or microcrystalline, generally referring to the size of crystal grains suspended in an amorphous phase. Solids having larger crystal grains are referred to as microcrystalline, whereas those with smaller crystal grains are nanocrystalline. It should be noted that the term "crystalline silicon" may refer to any form of silicon having a crystal phase, including microcrystalline and nanocrystalline silicon.

Figure 1 is a schematic diagram of an embodiment of a multi-junction solar cell 100 oriented toward the light or solar radiation 101. Solar cell 100 comprises a substrate 102, such as a glass substrate, polymer substrate, metal substrate, or other suitable substrate, with thin films formed thereover. The solar cell 100 further comprises a first transparent conducting oxide (TCO) layer 104 formed over the substrate 102, and a first p-i-n junction 126 formed over the first TCO layer 104. In one configuration, a wavelength selective reflector (WSR) layer 112 is formed over the first p-i-n junction 126. A second p-i-n junction 128 formed over the first p-i-n junction 126, a second TCO layer 122 is formed over the second p-i-n junction 128, and a metal back layer 124 formed over the second TCO layer 122. In one embodiment, a WSR layer 112 is disposed between the first p-i-n junction 126 and the second p-i-n junction 128, and is configured to have film properties that improve light scattering and current generation in the formed solar cell 100. Additionally, the WSR layer 112 also provides a good p-n tunnel junction that has a high electrical conductivity and a tailored bandgap range that affects its transmissive and reflective properties to improve the formed solar cell's light conversion efficiency.

To improve light absorption by enhancing light trapping, the substrate and/or one or more of the thin films formed thereover may be optionally textured by wet, plasma, ion etching, and/or mechanical processes. For example, in the embodiment shown in Figure 1, the first TCO layer 104 is textured and the subsequent thin films deposited thereover will generally follow the topography of the surface below it.

The first TCO layer 104 and the second TCO layer 122 may each comprise tin oxide, zinc oxide, indium tin oxide, cadmium stannate, combinations thereof, or other suitable materials. It is understood that the TCO materials may also include additional dopants and components. For example, zinc oxide may further include dopants, such as aluminum, gallium, boron, and other suitable dopants. Zinc oxide preferably include 5 atomic % or less of dopants, and more preferably comprises 2.5 atomic % or less aluminum. In certain instances, the substrate 102 may be provided by the glass manufacturers with the first TCO layer 104 already provided.

The first p-i-n junction 126 may comprise a p-type amorphous silicon layer 106, an intrinsic type amorphous silicon layer 108 formed over the p-type amorphous silicon layer 106, and an n-type microcrystalline silicon layer 110 formed over the intrinsic type amorphous silicon layer 108. In certain embodiments, the p-type amorphous silicon layer 106 may be formed to a thickness between about 60Å and about 300Å. In certain embodiments, the intrinsic type amorphous silicon layer 108 may be formed to a thickness between about 1,500Å and about 3,500Å. In certain embodiments, the n-type microcrystalline semiconductor layer 110 may be formed to a thickness between about 100Å and about 400Å.

The WSR layer 112 disposed between the first p-i-n junction 126 and the second p-i-n junction 128 is generally configured to have certain desired film properties. In this configuration the WSR layer 112 actively serves as an intermediate reflector having a desired refractive index, or ranges of refractive indexes, to reflect light received from the light incident side of the solar cell 100. The WSR layer 112 also serves as a junction layer that boosts the absorption of the short to mid wavelengths of light (e.g., 280nm to 800nm) in the first p-i-n junction 126 and improves short-circuit current, resulting in improved quantum and conversion efficiency. The WSR layer 112 further has high film transmittance for mid to long wavelengths of light (e.g., 500nm to 1100nm) to facilitate the transmission of light to the layers formed in the junction 128. Further, it is generally desirable for the WSR layer 112 to absorb as little light as possible while reflecting desirable wavelengths of light (e.g., shorter wavelengths) back to the layers in the first p-i-n junction 126 and transmitting desirable wavelengths of light (e.g., longer wavelengths) to the layers in the second p-i-n junction 128.

In one embodiment, the WSR layer 112 may comprise an n-type doped silicon alloy layer, such as silicon oxide (SiOₓ, SiO₂) silicon carbide (SiC), silicon oxynitride (SiON), silicon nitride (SiN), silicon carbon nitride (SiCN), silicon oxycarbide (SiOC), silicon oxycarbon nitride (SiOCN), or the like. In an exemplary embodiment, the WSR layer 112 is an n-type SiON or SiC layer.

The second p-i-n junction 128 may comprise a p-type microcrystalline silicon layer 114 and, in some cases, an optional p-i buffer type intrinsic amorphous silicon (PIB) layer 116 that is formed over the p-type microcrystalline silicon layer 114. Subsequently, an intrinsic type microcrystalline silicon layer 118 is formed over the p-type microcrystalline silicon layer 114, and an n-type amorphous silicon layer 120 formed over the intrinsic type microcrystalline silicon layer 118. In certain embodiments, the p-type microcrystalline silicon layer 114 may be formed to a thickness between about 100Å and about 400Å. In certain embodiments, the p-i buffer type intrinsic amorphous silicon (PIB) layer 116 may be formed to a thickness between about 50 Å and about 500 Å. In certain embodiments, the intrinsic type microcrystalline silicon layer 118 may be formed to a thickness between about 10,000Å and about 30,000Å. In certain embodiments, the n-type amorphous silicon layer 120 may be formed to a thickness between about 100Å and about 500Å.

The metal back layer 124 may include, but is not limited to a material selected from the group consisting of Al, Ag, Ti, Cr, Au, Cu, Pt, alloys thereof, or combinations thereof. Other processes may be performed to form the solar cell 100, such as a laser scribing processes. Other films, materials, substrates, and/or packaging may be provided over the metal back layer 124 to complete the solar cell device. The formed solar cells may be interconnected to form modules, which in turn can be connected to form arrays.

Solar radiation 101 is primarily absorbed by the intrinsic layers 108, 118 of the p-i-n junctions 126, 128 and is converted to electron-holes pairs. The electric field created between the p-type layer 106, 114 and the n-type layer 110, 120 that stretches across the intrinsic layer 108, 118 causes electrons to flow toward the n-type layers 110, 120 and holes to flow toward the p-type layers 106, 114 creating a current. The first p-i-n junction 126 comprises an intrinsic type amorphous silicon layer 108 and the second p-i-n junction 128 comprises an intrinsic type microcrystalline silicon layer 118 since amorphous silicon and microcrystalline silicon absorb different wavelengths of the solar radiation 101. Therefore, the formed solar cell 100 is more efficient, since it captures a larger portion of the solar radiation spectrum. The intrinsic layer 108, 118 of amorphous silicon and the intrinsic layer of microcrystalline are stacked in such a way that solar radiation 101 first strikes the intrinsic type amorphous silicon layer 118 and is transmitted through the WSR layer 112 and then strikes the intrinsic type microcrystalline silicon layer 118 since amorphous silicon has a larger bandgap than microcrystalline silicon. Solar radiation not absorbed by the first p-i-n junction 126 continuously transmits through the WSR layer 112 and continues on to the second p-i-n junction 128.

Charge collection is generally provided by doped semiconductor layers, such as silicon layers doped with p-type or n-type dopants. P-type dopants are generally group III elements, such as boron or aluminum. N-type dopants are generally group V elements, such as phosphorus, arsenic, or antimony. In most embodiments, boron is used as the p-type dopant and phosphorus as the n-type dopant. These dopants may be added to the p-type and n-type layers 106, 110, 114, 120 described above by including boron-containing or phosphorus-containing compounds in the reaction mixture. Suitable boron and phosphorus compounds generally comprise substituted and unsubstituted lower borane and phosphine oligomers. Some suitable boron compounds include trimethylboron (B(CH₃)₃ or TMB), diborane (B₂H₆), boron trifluoride (BF₃), and triethylboron (B(C₂H₅)₃ or TEB). Phosphine is the most common phosphorus compound. The dopants are generally provided with carrier gases, such as hydrogen, helium, argon, and other suitable gases. If hydrogen is used as the carrier gas, it adds to the total hydrogen in the reaction mixture. Thus hydrogen ratios will include hydrogen used as a carrier gas for dopants.

Figure 2 is a schematic side-view of a single-junction thin-film solar cell 200 according to another embodiment of the invention, which might in some instances use a light trapping improvement. The embodiment of Figure 2 differs from that of Figure 1 by inclusion of a p-type crystalline silicon alloy layer 206 between the p-type amorphous silicon layer 208 and the first TCO layer 104 of Figure 1. Alternatively, the p-type crystalline silicon alloy layer 206 may be a degeneratively doped layer having p-type dopants heavily doped in the alloy layer 206. The embodiment of Figure 2 thus comprises the substrate 102 on which a conductive layer 204, such as a TCO layer similar to the first TCO layer 104 of Figure 1, is formed. As described above, a p-type crystalline silicon alloy layer 206 is formed over the conductive layer 204. The p-type crystalline silicon alloy layer 206 has improved bandgap due to lower doping, adjustable refractive index generally lower than that of a degeneratively doped layer, high conductivity, and resistance to oxygen attack by virtue of the included alloy components. A p-i-n junction 220 is formed over the p-type crystalline silicon alloy layer 206 by forming a p-type amorphous silicon layer 208, a PIB layer 210, an intrinsic amorphous silicon layer 212, and an n-type amorphous silicon layer 214. The solar cell 200 of Figure 2 is completed, similarly to the foregoing embodiments, with an n-type crystalline silicon alloy layer 216, which is similar to the WSR layer 112 of Figure 1, and a second conductive layer 218, which may be a metal or metal/TCO stack, similar to the conductive layers 122, 124 of Figure 1.

According to different embodiments, a plurality methods and system/apparatus configurations for texturing a semiconductor precursor can be utilized in embodiments described herein. As described above, the layers, particularly the TCO layer 104 is generally textured in order to improve light trapping and, thus, the efficiency of a solar cell. In the following, it is exemplarily referred to etching of zinc oxide (ZnO) layers as a font contact of precursors for a solar thin film. However, the same principles can be applied to other semiconductor device manufacturing methods.

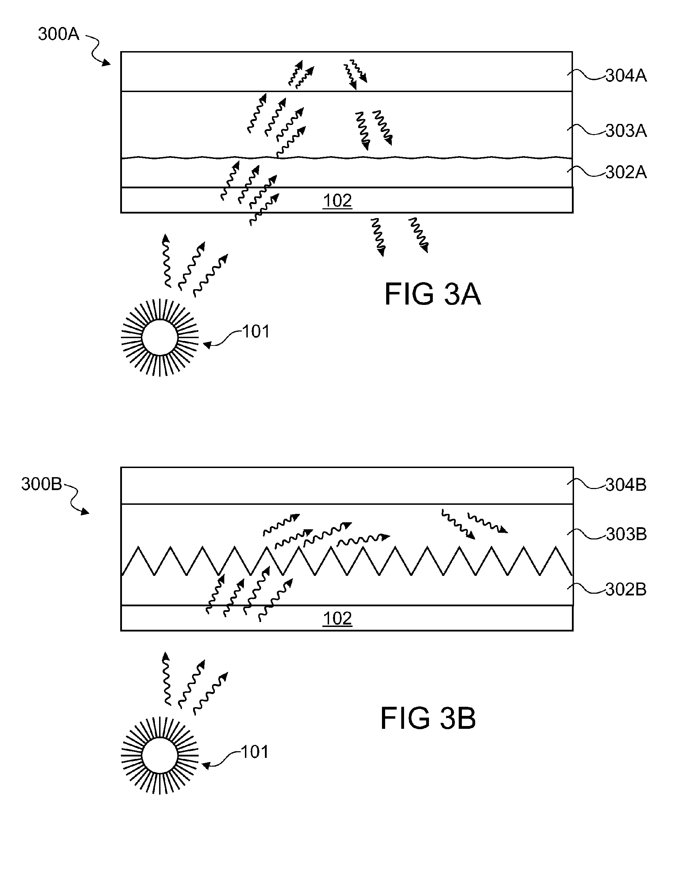

As illustrated with respect to figures 3A and 3B, texturing of layers or films in the semiconductor device can, for example, improve light trapping. Figures 3A and 3B show the semiconductor device precursor 300A and 300B, respectively. Layers 302A, 303A, 304A and 302B, 303B, 303C, respectively, are deposited above the substrate 102. As shown in figure 3A, the layer 302 has a flat or almost flat upper surface. In light thereof, a portion of a radiation source 101, such as the sun for a solar cell device, can be reflected within the semiconductor device precursor. This is indicated by a portion of the photons being reflected at the upper surface of layer 304A in figure 3A. Thereby, the photons can leave the layer stack for a solar cell after a comparable short path length. Contrary thereto, as shown in figure 3B, a textured surface 302B increases the likelihood of all, or at least 90 % of the photons enter the semiconductor device. Further, the photons are diffracted at the boundaries of the layers such that the photons might even remain in one layer by total internal reflection upon diffraction at the textured TCO layer. Thereby, the path length within the desired layer in which photons should be absorbed for light conversion is increased. This does generally improve the efficiency of the layer stack for the solar cell.

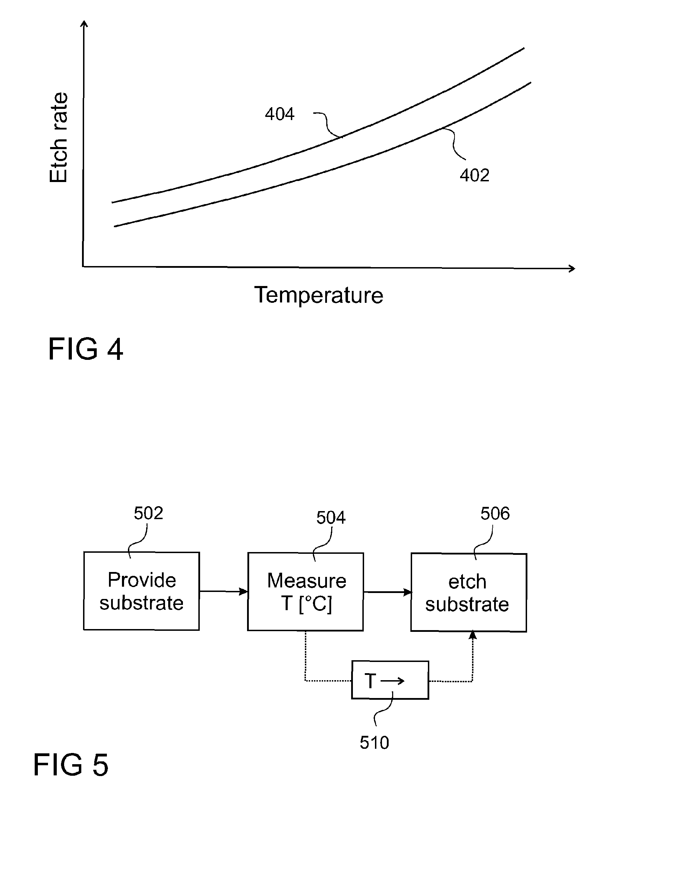

In the following, improved light trapping due to texturing of layer surfaces will be exemplarily described by means of etching metal oxide layers of solar thin film devices. However, these principles, which might be particularly relevant for layer stacks for solar cells, can also apply for other semiconductor device manufacturing methods and other corresponding semiconductor devices. As shown in figure 4, it has been shown that isotropic etching of zinc oxide layers of, for example, a front contact of a layer stack for a solar thin film application, can be sensitive for temperature variations. Thereby, typically temperature variations in the range of a few degrees centigrade, such as ± 2, ± 5, or ± 10°C show a significant sensitivity for the etching processes. Accordingly, the temperature axis in figure 4 shows only a few degrees centigrade variation.

As shown in figure 4, higher temperatures lead to increased etch rates, whereas lower temperatures reduce the etch rate of the film to be textured.

According to embodiments, which can be combined with other embodiments described herein, typically a wet etch process can be applied for texturing a layer of a semiconductor device precursor. Figure 4 shows two curves 402 and 404, each of which are illustrated to show an exponential increase of the etch rate with temperature. The deviation of the two curves can for example be due to concentration of the etchant, the flow distribution of the etchant on the film, the layer, the type of etchant, or other parameters. According to yet further embodiments, alternatively non-exponential etch rate dependencies from the temperature can be experienced, which can, for example, be described by a linear regression, polynomial regression or other functions.

According to typical embodiments, two sources of temperature variations might be of influence for the texturing of the layer. These are the substrate temperature and the temperature of the etchant, e.g. in an etch bath. Thereby, the control of the liquid etchant can be conducted in a bath or, in the case of spraying, by heating the etchant tank, a conduit for guiding the etchant to the etch region and/or a spray nozzle to the desired temperature. According to typical embodiments, the temperature of the etchant is controlled such that an equilibrium temperature condition and/or a uniform temperature is provided. However, the control of the substrate temperature is generally more difficult to conduct, particularly in light of the temperature variation of the substrates in the processing line, which can be for example ± 25°C or more from one sheet to the next sheet. Even though the conditioning step for adjusting the substrate temperature in a predetermined temperature range can be optionally provided for some embodiments described herein, adjustment of the substrate temperature in a sufficiently small temperature range will significantly increase the technical effort and the costs of semiconductor device manufacturing.

According to embodiments described herein, a feed forward or a closed loop control is provided based on a measured temperature correlating to the substrate temperature. This measured temperature value is then used to vary a parameter of the etching process in order to adapt to the substrate temperature. For example, one parameter that can be varied depending on the substrate temperature can be the process time for etching.

According to different embodiments, which can be combined with other embodiments described herein, the room temperature in which the substrates are stored can be measured and/or the temperature of the substrate itself can be measured. Measurements can for example be conducted by a pyrometer, an infrared camera or a thermometer. According to different embodiments, which can be combined with other embodiments described herein, the temperature of the substrate can be directly measured or indirectly measured, e.g. by measuring a room temperature or the like. Further, contactless measurements, contact measurements and combinations thereof can be used for measuring the substrate temperature. A temperature value is measured that gives sufficient correlation with respect to the substrate temperature of the substrate to be etched. The measured value is then used to control the etching process. For example the process time for etching, the etchant concentration and/or another temperature in used as a parameter of the etching process can be controlled. If for example a dry etching process is conducted, further parameters like a plasma density, a chamber pressure, a power for driving the plasma, or a frequency of this power can be used as parameters.

Thereby, according to some embodiments, the adjustment of one or more of the above parameters can be based on an equation, a calibration curve, a lookup table, and/or the like. Thereby, improved repeatability by reduced effort for conditioning of a substrate can be provided for a surface texturing process.

Accordingly, a process parameter for the etching process, such as the etching time, that is the etching time period, can be adjusted depending on a measured temperature correlating to the substrate temperature such that deviation in etch results from one substrate to another substrate can be reduced or minimized.

According to some embodiments, which can be combined with other embodiments described herein, this can be utilized for isotropic wet etching of metal oxides, such as zinc oxide. Thereby, according to some embodiments, which can be combined with other embodiments described herein, a layer thickness of 400 - 1200 nm of a semiconductor layer to be etched can be provided.

According to yet another embodiment, which can be combined with other embodiments described herein, such an improved manufacturing process can be particularly relevant for texturing of a transparent conductive oxide layer of the thin-film solar cell or a layer stack for manufacturing the thin-film solar cell that is a precursor of a thin-film solar cell.

One embodiment of a method for etching a semiconductor device precursor, for example the front contact layer or another TCO layer of solar cell layer stack, is shown in figure 5. Therein, the substrate is provided in step 502. A temperature associated with the substrate or correlated to the substrate temperature is measured or determined in step 504. In step 506 the metal oxide layer of the substrate is etched, wherein the measured temperature is an input parameter for the etching in step 506 as indicated by reference number 510. According to yet further embodiments, which can be combined with other embodiments described herein, the measured temperature can be one temperature chosen from, for example, a temperature of an ambient atmosphere of the substrate, a temperature of the storing device for the substrate, the room in which the substrate is stored, and/or the substrate temperature itself. Typically, the substrate temperature can be measured before the substrate enters an etching chamber or while the substrate enters the etching chamber.

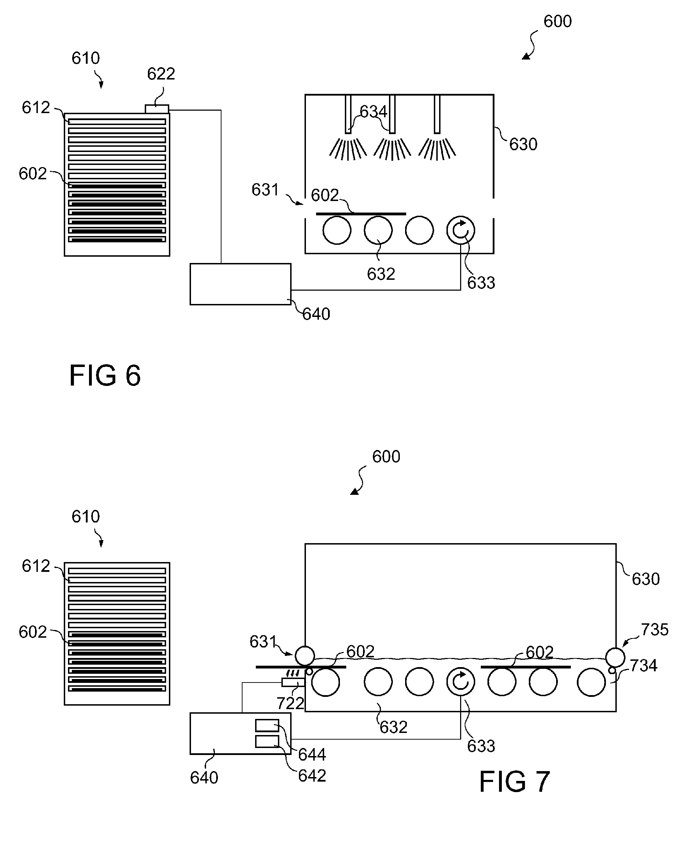

Figure 6 illustrates embodiments of a device 600 for etching a semiconductor device precursor 602. Within figure 6, a storage rack 610 for storing one or more substrates 602, i.e. semiconductor device precursors. The substrates 602 in the storage device 610 are to be etched in the chamber 630. Typically, the storage rack 610 can have slots 612 or other substrate support spaces like shelves, each one shelf capable of supporting one substrate. A thermometer 622 measures temperature in the rack 610 and thereby determines the ambient temperature of the storage device of the substrates. Additionally or alternatively, the temperature in the factory or plant, where the substrates are stored, can be measured. Thereby, for example, the ambient temperature can be controlled by air conditioning or the like. The value of the temperature measurement from the thermometer 622 is sent to controller 640. Further, the controller 640 can control one or more of the process parameters for the etching process. As shown in figure 6, the substrate 602 is fed into the etching chamber 630 via an opening 631. Thereby, for example, the etching chamber 630 can be one chamber of an in-line production system and the opening 631 can connect the chamber 630 to a neighboring chamber. Typically, the opening 631 can be closed by a valve such that atmospheric conditions of neighboring chambers do not influence the atmosphere in the chamber 630 and vice versa. As indicated by nozzles 634 an etching fluid is provided towards the substrate 602 while the substrate is transported on rollers 632 through the chamber 630. Thereby, as shown in figure 6, the rotation of the rollers 632 is indicated by arrow 633. The controller controls the rotation speed of the rollers 632 and, thus, the time during which the substrate 602 remains in the chamber 630. Accordingly, a transport speed and, thus, the etching times are controlled by a control unit 640. In light of the above, embodiments described herein provide a feed forward or a closed loop control for an etching process. Thereby, on the one hand, one determined temperature is used in a feed forward control step. On the other hand, additionally, the result can be evaluated by inspecting the etched substrate precursor such that a verification can be conducted in order to establish a closed loop control. Such a second measurement can also be used for a self-learning methodology, such as a fuzzy algorithm or the like in order to further improve the closed loop control.

Further embodiments are illustrated with respect to figure 7. Therein, a substrate support rack 610 with substrate support slots 612 or substrate support shelves are provided. Typically, one or more substrates 602 can be supported in the rack. The chamber 630 shown in figure 7 includes an etching bath 734 and the substrate 602 is transported through the etching bath 734 on rollers 632. According to typical embodiments, the substrates 602 can enter the chamber 630 through opening 631. As shown in figure 7, according to additional or alternative modifications of embodiments described herein, the substrate temperature can be measured with a pyrometer or an infrared camera as indicated by reference number 722 in figure 7. According to yet further embodiments, which can be combined with other embodiments described herein, the temperature can be measured from the bottom side in Fig. 7, which is the glass side of the device precursor.

The measurement result of the detector 722 is sent to a controller 640. Typically, the controller has CPU 642 and memory 644. According to the embodiments described herein, the etching process, for which parameters are controlled, is typically a wet etching process. Thereby, particularly for the texturing of layers for improved light trapping isotropic etching can be conducted. However, according to yet other embodiments, different etching processes, for example, also anisotropic etching processes can be controlled similarly depending on the temperature of the substrate to be etched.

The controller 640 shown in figure 7 includes a CPU 642 and a memory 644. The CPU can be used to calculate the desire adjustment of one or more etching parameters. The memory can be used to store calibration curves, lookup tables or other means that can be used for calculating the desired parameter adjustment.

According to typical embodiments, equations for calculating the appropriate adjustment(s) depending on the measured temperature can be based on theoretical calculations, expert knowledge, empirical data, or the like. Further, such equations can be equations of calibration curves wherein parameters of a calibration curve can, for example, be generated due to regression methods such as linear or non-linear least squares regression analysis methods. According to yet further embodiments, which can be combined with other embodiments described herein, also self teaching or learning methods such as, for example, methods based on fuzzy logic or the like can be applied. The example shown in figure 7 illustrates control of the rotation speed of the rollers 632 and thereby of the etching time.

According to some embodiments, which can be combined with other embodiments described herein, the methods and devices for etching semiconductor device precursors can be applied for large area thin films. For example, substrate sizes of 1.43 m² (Gen5) and above such as 5.7 m² (Gen8.5) or bigger can be realized. Further typical embodiments relate to aluminum doped zinc oxide layers (ZnO:A1) which can be sputtered from rotatable ceramic zinc oxide aluminum oxide (ZnO:A12O3) targets. Typically, the aluminum doped zinc oxide layers form a front contact of a solar cell. According to yet further embodiments, the TCO layer can be wet-chemically etched, for example in diluted hydrochloric acid, or other suitable etchants. Thereby, as described above, the etching process is of importance for the surface texture, which is used to scatter the light, particularly the long wavelength light.

Typically, the shape and feature size of the etched semiconductor layer depends on the parameters of the layer as well as the etching process. Accordingly, for a predetermined semiconductor layer with certain characteristics, the etching needs to be adjusted, such that the desired texture of the layer is generated. Thereby, typically the size of the craters increases with etching time, which correlates, for example, with an increase of the root mean square roughness.

According to some embodiments, which can be combined with other embodiments described herein, the texture and/or morphology can be improved by parameters like etch time, temperature, and other parameters described herein. In order to improve the processes or in order to provide, for example, a closed loop control with a controller, measurement methods for the root mean square roughness, light measurements of scattered light, the measurement methods for resistance of the etched layer, other methods of characterizing the etched layer and combinations thereof can be conducted.

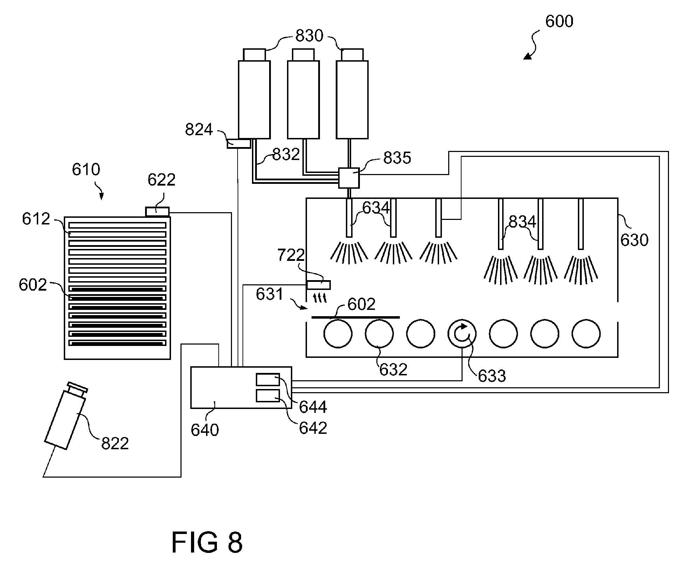

Figure 8 illustrates yet further embodiments of a device 600 for etching a semiconductor device precursor 602. As described above with respect to FIGS. 6 and 7, a storage rack 610 for storing one or more substrates 602, i.e. semiconductor device precursors is provided. The substrates 602 in the storage device 610 are to be etched in the chamber 630. Typically the storage rack 610 can have slots 612 or other substrate support means like shelves, each one shelf capable of supporting one substrate. A thermometer 622 measures temperature in the rack 610 and thereby determines the ambient temperature of the storage device of the substrates. The value of the temperature measurement from the thermometer 622 is sent to controller 640, which is shown to have CPU 642 and memory 644. As shown in figure 6, the substrate 602 is fed in the etching chamber 630 via an opening 631. Thereby, for example, the etching chamber 630 can be one chamber of an in-line production system and the opening 631 can connect the chamber 630 to a neighboring chamber. Typically, the opening 631 can be closed by a valve such that atmospheric conditions of neighboring chambers do not influence the atmosphere in the chamber 630 and vice versa. As indicated by nozzles 634 an etching fluid is provided towards the substrate 602 while the substrate is transported on rollers 632 through the chamber 630. Thereby, as shown in figure 8, the rotation of the rollers 632 is indicated by arrow 633.

According to different embodiments, which can be combined with other embodiments described herein, the etching time can be controlled by the transport speed and/or the transport behavior. Thereby, the transport behavior can include one or more of the following: stopping the transport in the etching chamber, moving the substrate 602 back and forth in the transport chamber; varying the transport speed; and adjusting a continuous transport speed.

Further, according to additional or alternative modifications of embodiments described herein, the substrate temperature can in addition be measured with a pyrometer or an infrared camera as indicated by reference number 722. According to the embodiments described herein, the etching process, for which parameters are controlled, is typically a wet etching process. Thereby, particularly for texturing of layers for improved light trapping isotropic etching can be conducted. However, according to yet other embodiments, different etching processes, for example, also anisotropic etching processes can be controlled similarly depending on the temperature of the substrate to be etched.

The CPU 462 can be used to calculate the desire adjustment of one or more etching parameters. The memory can be used to store calibration curves, lookup tables or other means that can be used for calculating the desired parameter adjustment. According to typical embodiments, equations for calculating the appropriate adjustment depending on the measured temperature can be based on theoretical calculations, expert knowledge, empirical data, or the like. Further, such equations can be equations of calibration curves wherein parameters of a calibration curve can, for example, be generated due to regression methods such as linear or non-linear least squares regression analysis methods. According to yet further embodiments, which can be combined with other embodiments described herein, also self teaching or learning methods such as, for example, methods based on fuzzy logic or the like can be applied.

The controller controls the rotation speed of the rollers 632 and, thus, the time during which the substrate 602 remains in the chamber 630. Accordingly, a transport speed and, thus, the etching times are controlled by a control unit 640. According to different embodiments, which can be combined with other embodiments described herein, the etching time can be controlled by the transport speed and/or the transport behavior. Thereby, the transport behavior can include one or more of the following: stopping the transport in the etching chamber, moving the substrate 602 back and forth in the transport chamber; varying the transport speed; and adjusting a continuous transport speed. In light of the above, embodiments described herein provide a closed loop control for an etching process.

As further shown in figure 8, an infrared camera 822 is used to measure the room temperature, particularly in the area of the substrate support device 610. Further, as an alternative or additional implementation, a thermometer 824 for measuring that temperature of the liquid etchant, which is provided in one of tanks 830 can be provided.

According to yet further embodiments, the etchant can be provided in one or more of the tanks 830. Other fluids like water for diluting the etchant can also be provided in one of the tanks. Thereby, the concentration of the acid can be adjusted in a mixing device 835.

As shown in figure 8, further nozzles 834 can be provided after the nozzles 634 for spraying the etchant, such that the nozzles 834 wash of the etchant from the substrate 602 in order to stop the etching process.

As indicated by the control lines of the controller 640, which is connected to the substrate transport rollers 632, the nozzles 634, and the mixing device 835, the etching process can be controlled by one or more parameters such as the etching time, the concentration of the etchant, the type of the etchant (if different actions are provided in the tanks 830) and the spraying condition of the etchant.

In light of the above a plurality of embodiments are described herein. According to one embodiment, a method for etching a device precursor is provided. The method includes: providing a substrate, determining a temperature associated with the substrate, and etching a metal oxide layer of the substrate, wherein the etching is controlled based on the determined temperature. According to typical modifications thereof, which yield yet further embodiments, in the step of determining a temperature at least one temperature can be determined chosen from: a temperature of an ambient atmosphere of the substrate; a temperature of an ambient atmosphere of the substrate during storage of the substrate; and a temperature of the substrate. According to yet further additional or alternative modifications the etching can be controlled by a closed loop control or a feed forward control, and/or the etching can be controlled by at least one step chosen from: providing the process time for etching depending on the determined temperature; providing the process time for etching by calculation; providing the process time for etching by calculation based on at least one equation; providing the process time for etching by calculation based on at least one calibration curve; adjusting the process time for etching; and adjusting the process time for etching depending on the determined temperature. Yet further alternative or additional modifications may include performing the method of any of the embodiments described herein repeatedly using a plurality of substrates and an etching deviation is reduced to a value of ± 5 rel.-% or below of the root mean squared roughness for each substrate; the metal oxide layer can include at least one element chosen from a transition metal, a post-transition metal, Zn, Sn, ZnO, and SnO; and/or the substrate can be chosen from the group consisting of: a semiconductor device substrate, a coated semiconductor device substrate, a semiconductor device precursor, a substrate of a thin film solar cell, a coated substrate of a thin film solar cell, a transparent substrate, a flexible substrate, a glass substrate, and a thin film solar cell precursor. According to yet further alternative or additional modifications, the metal layer can be deposited on the substrate before etching and/or the etching can be at least one process chosen from the group consisting of: an isotropic etching, an anisotropic etching, dry etching, and wet etching. Typically, the determining of the temperature can be performed by a contactless measurement.

According to a yet further embodiment a device for etching a device precursor is provided. The device includes a substrate support adapted to support a substrate, a temperature sensing device adapted to determine a temperature associated with the substrate, an etching device adapted to etch a metal oxide layer of the substrate, and a control device adapted to control the etching device based on the determined temperature associated with the substrate. According to typical modifications thereof the temperature sensing device is adapted to determine at least one temperature chosen from the group consisting of: a temperature of an ambient atmosphere of the substrate, a temperature of an ambient atmosphere of the substrate during storage of the substrate, a temperature of the substrate, and combinations thereof. According to yet further additional or alternative modifications, the temperature sensing device can include at least one element chosen from the group consisting of: a contactless sensing device, a pyrometer, an Infrared camera, and a thermocouple; the control device can be a closed loop controller or a feed forward controller; and/or the control device is adapted to provide at least one element chosen from the group consisting of: a process time for etching, a process time for etching in dependence on the determined temperature, a process time for etching by calculation, a process time for etching by calculation based on at least one equation, a process time for etching by calculation based on at least one calibration curve, an adjustment of the process time for etching, an adjustment of the process time for etching in dependence on the determined temperature, a concentration of the etchant, and a further temperature providing a parameter in the etching process. According to yet further additional or alternative modifications, the etching device can be selected from the group consisting of: an isotropic etching device, an anisotropic etching device, a dry etching device and a wet etching device; and /or can further include a coating device adapted to deposit the metal oxide layer on the substrate, e.g., wherein the coating device is a sputtering device.

While the foregoing is directed to embodiments of the present invention, other and further embodiments of the invention may be devised without departing from the basic scope thereof, and the scope thereof is determined by the claims that follow.

## Claims

1. A method for etching a device precursor, comprising providing a substrate;
determining a temperature associated with the substrate; and
etching a metal oxide layer of the substrate;
wherein the etching is controlled based on the determined temperature.

2. The method of claim 1, wherein in the step of determining a temperature at least one temperature is determined chosen from:
a temperature of an ambient atmosphere of the substrate;
a temperature of an ambient atmosphere of the substrate during storage of the substrate; and
a temperature of the substrate.

3. The method of any of the preceding claims,
wherein the etching is controlled by a closed loop control or a feed forward control, and/or
wherein the etching is controlled by at least one step chosen from:
providing the process time for etching depending on the determined temperature;
providing the process time for etching by calculation;
providing the process time for etching by calculation based on at least one equation;
providing the process time for etching by calculation based on at least one calibration curve;
adjusting the process time for etching; and
adjusting the process time for etching depending on the determined temperature.

4. The method of any of the preceding claims,
wherein the method of any of the preceding claims is repeatedly performed using a plurality of substrates and an etching deviation is reduced to a value of ± 5 rel.-% or below of the root mean squared roughness or the resistance for each substrate.

5. The method of any of the preceding claims, wherein the metal oxide layer comprises at least one element chosen from a transition metal, a post-transition metal, Zn, Sn, ZnO, and SnO.

6. The method of any of the preceding claims, wherein the substrate is chosen from
a semiconductor device substrate,
a coated semiconductor device substrate,
a semiconductor device precursor,
a substrate of a thin film solar cell,
a coated substrate of a thin film solar cell,
a transparent substrate,
a flexible substrate;
a glass substrate, and
a thin film solar cell precursor.

7. The method of any of the preceding claims,
wherein the metal layer is deposited on the substrate before etching; and/or
wherein the etching is at least one process chosen from
an isotropic etching,
an anisotropic etching,
dry etching, and
wet etching.

8. The method of any of the preceding claims, wherein the determining of the temperature is performed by a contactless measurement.

9. A device for etching a device precursor, comprising a substrate support adapted to support a substrate;
a temperature sensing device adapted to determine a temperature associated with the substrate;
an etching device adapted to etch a metal oxide layer of the substrate; and
a control device adapted to control the etching device based on the determined temperature associated with the substrate.

10. The device of claim 9, wherein the temperature sensing device is adapted to determine at least one temperature chosen from:
a temperature of an ambient atmosphere of the substrate;
a temperature of an ambient atmosphere of the substrate during storage of the substrate; and
a temperature of the substrate.

11. The device of any of claims 9 and 10, wherein the temperature sensing device comprises at least one element chosen from the group consisting of: a contactless sensing device, a pyrometer, an Infrared camera, and a thermocouple.

12. The device of any of claims 9 to 11, wherein the control device is a closed loop controller or a feed forward controller.

13. The device of any of claims 9 to 12, wherein the control device is adapted to provide at least one element chosen from:
a process time for etching;
a process time for etching in dependence on the determined temperature;
a process time for etching by calculation;
a process time for etching by calculation based on at least one equation;
a process time for etching by calculation based on at least one calibration curve;
an adjustment of the process time for etching;
an adjustment of the process time for etching in dependence on the determined temperature;
a concentration of the etchant, and
a further temperature providing a parameter in the etching process.

14. The device of any of claims 9 to 13, wherein the etching device is selected from the group consisting of: an isotropic etching device, an anisotropic etching device, a dry etching device and a wet etching device.

15. The device of any of claims 9 to 14, comprising
a coating device adapted to deposit the metal oxide layer on the substrate; and/or wherein the coating device is a sputtering device.
